# EUROPEAN PATENT APPLICATION

(11) **EP 4 456 047 A1**
(43) Date of publication of application: **30.10.2024**
(21) Application number: 22910669.5
(22) Date of filing: 15.11.2022
(51) Int. Cl.: G09F 9/00, G09F 9/30, G09F 9/33, H01L 33/20, H01L 33/60

(54) **MICRO-LED DISPLAY AND METHOD FOR MANUFACTURING SAME**

(30) Priority: 21.12.2021 JP 2021206962
(71) Applicant: Nitride Semiconductors Co., Ltd., Naruto-shi, Tokushima 771-0360 (JP)
(72) Inventor: MURAMOTO Yoshihiko, Naruto-shi, Tokushima 771-0360 (JP)
(74) Representative: Osha BWB
(86) International application number: PCT/JP2022/042334
(87) International publication number: WO 2023/119950

(57) **Abstract**

Provided are a micro-LED display, and a method for manufacturing same, with which light emission efficiency is improved without the use of different types of micro-LEDs for each color. This micro-LED display comprises: a plurality of micro-UV-LED chips 1; and a film-shaped wavelength conversion layer 32 that comprises phosphors 28R, 20G, 28B that convert the wavelengths of ultraviolet light from the micro-UV-LED chips 1 into red, green and blue, respectively. Oblique surfaces are formed on side surfaces of each micro-UV-LED chip 1, and each micro-UV-LED chip 1 is surrounded by a reflecting barrier wall material 24 that reflects ultraviolet light emitted from the side surfaces.

## Description

### TECHNICAL FIELD

The present invention relates to a micro LED display and a manufacturing method thereof.

### BACKGROUND

In recent years, micro-LED displays have been expected to be the mainstay of nextgeneration displays for augmented reality (AR) and virtual reality (VR). Since the micro-LEDs are extremely small, with their chip size being equal to or less than 100 µm, it is difficult to achieve uniform emission intensity in a wafer plane.

In order to prevent leakage of light to adjacent pixels of image display elements and enhance luminous efficiency by reinforcing output of light in a front surface direction of the image display elements, Patent Literature 1 discloses a configuration including: micro light-emitting elements arranged in an array form, a drive circuit substrate including a drive circuit that supplies current to the micro light-emitting elements to allow emission of light; and light distribution control units (70) placed on light-emitting surfaces of the micro light-emitting elements, with a partition wall placed around each of the light distribution control units to block transmission of light emitted by the micro light-emitting elements.

### CITATION LIST

### PATENT LITERATURE

Patent Literature 1: JP 2021-144098 A

### SUMMARY

### TECHNICAL PROBLEM

Incidentally, micro-LED displays with a chip size of 100 µm or less have the following issues.
(1) Miniaturized micro-LED chips with a chip size of 50 µm or less, especially red LED chips that use GaP-based materials, have rapid degradation of luminous efficiency.
(2) Red LED chips made of GaP-based materials and blue and green LED chips made of InGaN-based materials are different in drive voltage and current, which not only complicates control, but also causes variation in electric characteristics and thereby causes color irregularity.
(3) It takes time to mount micro LED chips of three colors of red, green and blue by pick-and-place for every color, and manufacturing costs are increased.

The present invention has been made in view of such issues, and it is an advantage of the present invention to provide a micro LED display having enhanced luminous efficiency without using a different type of micro LED for each color, and a manufacturing method thereof.

### SOLUTION TO PROBLEM

The present invention relates to a micro LED display, including a first conductive-type electrode, a plurality of micro LEDs that are separately formed on the first conductive-type electrode and each configured to emit ultraviolet light with a wavelength of 405 nm or less, second conductive-type electrodes formed on the plurality of micro LEDs, respectively, a reflective barrier member erected between the plurality of micro LEDs to reflect light from side surfaces of the micro LEDs, a film-like wiring substrate having a wiring structure that is connected with the second conductive-type electrodes of three micro LEDs that are adjacent to each other, out of the plurality of micro LEDs, so as to constitute one pixel, and a film-like wavelength conversion layer provided on the wiring substrate, and including phosphors that perform wavelength conversion of respective light from the three micro LEDs into red, green, and blue colors. The side surfaces of the micro LEDs are formed into inclined surfaces such that widths of the micro LEDs gradually decrease from the first conductive-type electrode toward the second conductive-type electrodes, and the reflective barrier member is erected parallel to a stacking direction of the plurality of micro LEDs and up to a height equal to the micro LEDs.

One embodiment of the present invention further includes a phosphor-dispersed resin that is filled between the micro LEDs and the reflective barrier layer. In another embodiment of the present invention, the first conductive-type electrode is a conductive substrate made of tungsten copper.

The present invention is a manufacturing method of a micro LED display, the method including a step of epitaxially growing a GaN buffer layer, an n-type layer, a light-emitting layer, and a p-type layer on a sapphire substrate in order, a step of forming a transparent electrode on the p layer by vapor deposition, a step of bonding a conductive substrate onto the transparent electrode, a step of lifting off the sapphire substrate and the GaN buffer layer, a step of forming a plurality of micro LEDs by etching from a side of the n-type layer, while forming inclined surfaces on side surfaces of the micro LEDs, a step of forming n-electrodes on the plurality of micro LEDs by vapor deposition, respectively, a step of forming a passivation layer on parts of the plurality of micro LEDs other than the n-electrodes, a step of erecting a reflective barrier member between the plurality of LEDs, a step of forming a film-like wiring substrate on the n-electrodes such that three micro LEDs that are adjacent to each other, out of the plurality of micro LEDs, constitute one pixel, and a step of forming a film-like wavelength conversion layer on the wiring substrate, the wavelength conversion layer including phosphors that perform wavelength conversion of respective light from the three micro LEDs into red, green, and blue colors. The side surfaces of the micro LEDs are formed into inclined surfaces such that widths of the micro LEDs gradually decrease from the conductive substrate toward the n-type layer, and the reflective barrier member is erected parallel to a stacking direction of the plurality of micro LEDs and up to a height equal to the micro LEDs.

In one embodiment of the present invention, the step of erecting the reflective barrier the plurality of LEDs, and the step of forming the film-like wiring substrate on the n-electrodes such that three micro LEDs that are adjacent to each other, out of the plurality of micro LEDs, constitute one pixel, are concurrently performed.

Another embodiment of the present invention further includes a step of filling a phosphor-dispersed resin between the micro LEDs and the reflective barrier layer, after the step of erecting the reflective barrier between the plurality of LEDs.

In still another embodiment of the present invention, the conductive substrate is made of tungsten copper.

### ADVANTAGEOUS EFFECTS OF INVENTION

The present invention can provide a micro LED display having enhanced luminous efficiency without using a different type of micro LED for each color, and a manufacturing method thereof.

### BRIEF DESCRIPTION OF DRAWINGS

[FIG. 1] FIG. 1 is a schematic sectional view showing the basic configuration of a micro LED of an embodiment.
[FIG. 2A] FIG. 2A is a schematic sectional view of a micro-LED display of the embodiment.
[FIG. 2B] FIG. 2B is a schematic plan view of the micro-LED display of the embodiment.
[FIG. 3] FIG. 3 is a (first) schematic sectional view showing a manufacturing method of a micro-LED display of an embodiment.
[FIG. 4] FIG. 4 is a (second) schematic sectional view showing the manufacturing method of the micro-LED display of the embodiment.
[FIG. 5] FIG. 5 is a (third) schematic sectional view showing the manufacturing method of the micro-LED display of the embodiment.
[FIG. 6] FIG. 6 is a (fourth) schematic sectional view showing the manufacturing method of the micro-LED display of the embodiment.
[FIG. 7] FIG. 7 is a (fifth) schematic sectional view showing the manufacturing method of the micro-LED display of the embodiment.
[FIG. 8] FIG. 8 is a (sixth) schematic sectional view showing the manufacturing method of the micro-LED display of the embodiment.
[FIG. 9] FIG. 9 is a (seventh) schematic sectional view showing the manufacturing method of the micro-LED display of the embodiment.
[FIG. 10] FIG. 10 is a plan view of a film-like wiring substrate in the embodiment.
[FIG. 11] FIG. 11 is an (eighth) schematic sectional view showing the manufacturing method of the micro-LED display of the embodiment.
[FIG. 12] FIG. 12 is a schematic sectional view showing the manufacturing method of a micro-LED display in a first modification.
[FIG. 13] FIG. 13 is a (first) schematic sectional view showing the manufacturing method of a micro-LED display in a second modification.
[FIG. 14] FIG. 14 is a (second) schematic sectional view showing the manufacturing method of the micro-LED display in the second modification.

### DESCRIPTION OF EMBODIMENTS

Hereinafter, embodiments of the present invention will be described based on the drawings.

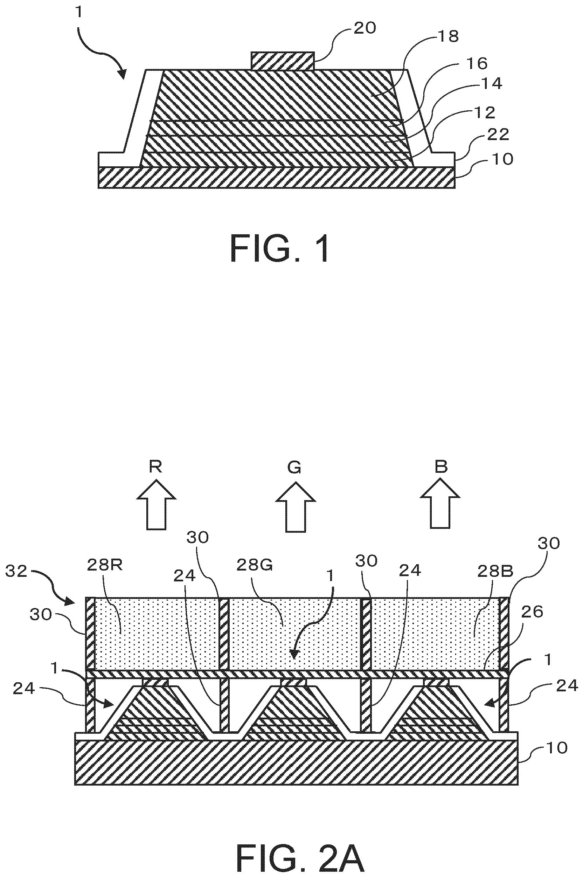

FIG. 1 shows a basic schematic sectional view of a micro LED used in a micro LED display of the present embodiment.

A micro LED 1 is an LED that emits ultraviolet light (UV) with a wavelength of 405 nm or less, with its chip size being at least 100 µm or less, preferably 50 µm or less, on each side in a rectangular planar shape. The micro LED 1 in the present embodiment is not in a flip-chip structure where electrodes are arranged in parallel, but is in a vertical V-chip structure where the electrodes are arranged in an up-down direction.

The micro LED 1 is formed by sequentially laminating a transparent electrode 12 made of ITO, a p-type layer 14, a light-emitting layer 16, an n-type layer 18, and an n-electrode 20 on a conductive substrate 10 made of, for example, tungsten copper (CuW) with a thickness of about 100 µm. The substrate 10 corresponds to the first conductive-type electrode, and the n-electrode 20 corresponds to the second conductive-type electrode.

The p-type layer 14 includes a p-GaN (GaN; mg) contact layer and an (AlGaN; Mg/ GaN; Mg) p-superlattice structure (SLS) layer. Specifically, the p-GaN contact layer is formed on the substrate 10, having heat dissipation characteristics, through the transparent electrode 12 made of ITO.

The light-emitting layer 16 includes an (InGaN/ AlGaN) multiple quantum well (MQW) layer.

The n-type layer 18 includes an (AlInGaN)/ (InGaN; Si) n-superlattice structure (SLS) layer and a (GaN; Si) contact layer.

Here, (GaN; Si) refers to GaN doped with Si, for example. An emission wavelength in such a configuration is specifically 385 nm, though the emission wavelength may be other values, such as 400 nm. Although the basic epitaxial structure is the same in both the cases where the emission length is 385 nm and 400 nm, the (InGaN/ AlInGaN) MQW light-emitting layer 16 with an emission wavelength of 385 nm has a higher Al content and a lower In content than the light-emitting layer 16 with an emission wavelength of 400 nm, in terms of band gap energy.

The side surface of the micro LED 1 is formed into an inclined surface (tapered surface) such that the width of the micro LED 1 gradually decreases in a stacking direction from the substrate 10 to the n-electrode 20, and a passivation layer 22 made of SiO2 is formed on the side surface formed into the inclined surface. The inclined surface may have any angle, though 45 degrees is preferable from the viewpoint of maximizing extraction efficiency, for example.

In the case of the micro LED 1, although micro-sizing generally causes a relative increase in side surface area, the efficiency of light extraction from the side surface is enhanced in the present embodiment, since a V-chip structure is adopted instead of a flip-chip structure. In addition, since the side surface is formed into an inclined surface shape, the area of the side surface of the light-emitting layer 16 can be made larger than that in the case where the side surface is vertical, so that the efficiency of light extraction from the side surface is further enhanced.

Moreover, by using the substrate 10 having excellent heat dissipation characteristics, such as a tungsten copper substrate, on the p-electrode side, it becomes possible to improve heat dissipation and to input a larger current, so that decrease in luminous efficiency due to heat generation can be suppressed.

FIG. 2A shows a schematic sectional view of a micro LED display using the micro LEDs 1 (hereafter referred to as micro UV-LED chips 1) shown in FIG. 1. On the common copper tungsten (CuW) substrate 10, a plurality (only three in the drawing) of micro UV-LED chips 1 are formed separately from each other. Note that on a flat surface, the plurality of micro UV-LED chips 1 are arranged in a two-dimensional array.

Between adjacent micro UV-LED chips 1, a reflective barrier member 24 is erected parallel to a stacking direction of the micro UV-LED chips 1, i.e., parallel to the direction normal to the surface of the substrate 10. The reflective barrier member 24 has functions of preventing leakage of light from the adjacent micro UV-LED chips 1 to other micro UV-LED chips 1, and increasing the light extraction efficiency in a light extraction direction (upward direction in the drawing) by reflecting light from a lateral direction of the micro UV-LED chips 1, and therefore, the reflective barrier member 24 is formed of a material, such as aluminum, that reflects light (ultraviolet light with a wavelength of 405 nm or less) from the side surfaces of the micro UV-LED chip 1. The height of the reflective barrier member 24 may be identical to the height of the micro UV-LED chips 1. The plurality of respective micro UV-LED chips 1 are surrounded with the reflective barrier member 24 and separated from each other.

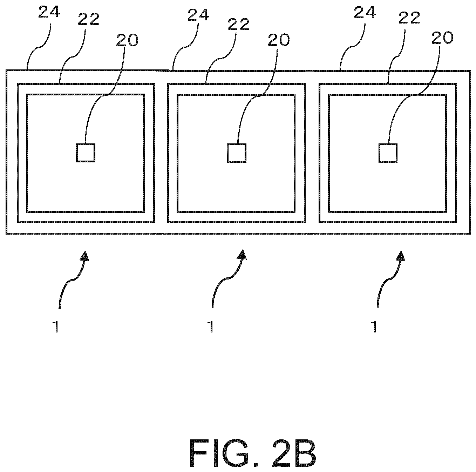

FIG. 2B is a schematic plan view showing the positional relationship between the micro UV-LED chips 1 and the reflective barrier member 24. The reflective barrier member 24 is formed so as to surround the micro UV-LED chips 1 having a rectangular planar shape. As is clear from FIG. 2A, the reflective barrier member 24 is formed on the SiO2 passivation layer 22. Since each of the micro UV-LED chips 1 is surrounded with the barrier member 24, all the light emitted from the side surface of the light-emitting layer 16 is reflected by the reflective barrier member 24.

Returning to FIG. 2A again, on the plurality of micro UV-LED chips 1, a film-like wiring substrate 26 is formed. The film-like wiring substrate 26 has three n-type electrodes formed to face the respective n-electrodes 20 of the three adjacent micro UV-LED chips 1, and the film-like wiring substrate 26 is laminated so that the respective n-electrodes 20 of the three adjacent micro UV-LED chips 1 are joined with the three n-type electrodes, respectively. At this time, since the height of the reflective barrier member 24 is equal to the height of the micro UV-LED chips 1, the film-like wiring substrate 26 is easily and uniformly laminated. The wiring substrate 26 includes a drive circuit that drives the plurality of micro UV-LED chips 1. The drive circuit includes a row-select circuit that selects each row of the micro UV-LED chips 1 arranged in a two-dimensional array, a column-select circuit that selects each column, and an image processing circuit that generates a light-emitting signal from an input signal.

On the film-like wiring substrate 26, R phosphor 28R, G phosphor 28G and B phosphor 28B are further applied, so as to form a film-like wavelength conversion layer 32 having high ultraviolet transmittance and including a barrier member 30 that partitions these phosphors 28R, 28G and 28B from each other. The R phosphor 28R is formed by, for example, dispersing phosphor powder in cured transparent resin, the phosphor powder receiving ultraviolet light from the micro UV-LED chips 1 and emitting red light with a longer wavelength than the ultraviolet light. The red phosphor powder is, for example, LOS: Eu. Green phosphor powder is, for example, BAM: Eu, Mn, and blue phosphor powder is, for example, BAM: Eu, though the phosphor powder is not limited to these. Here, LOS is La₂O₂S, and BAM is (Ba, Mg) Al₁₀O₁₇.

In FIG. 2A, the R phosphor 28R is arranged on the micro UV LED chip 1 positioned on the left side, out of the three adjacent micro UV LED chips 1, the G phosphor 28G is arranged on the micro UV-LED chip 1 positioned at the center, and the B phosphor 28B is arranged on the micro UV-LED chip 1 positioned on the right side, the three adjacent micro UV-LED chips 1 and the phosphors 28R, 28G, and 28B constituting one pixel. Ultraviolet light from the micro UV-LED chip 1 positioned on the left side, out of the three adjacent micro UV-LED chips 1, is converted to red wavelengths by the R phosphor 28R and emitted to the outside. The ultraviolet light from the micro UV-LED chip 1 positioned at the center is converted to green wavelengths by the G phosphor 28G and emitted to the outside. The ultraviolet light from the micro UV-LED chip 1 positioned on the right side is converted to blue wavelengths by the B phosphor 28B and emitted to the outside.

The ultraviolet light emitted from the inclined surface of the micro UV-LED chip 1 positioned on the left side, out of the three adjacent micro UV-LED chips 1, is reflected by the reflective barrier member 24 formed so as to surround the micro-UV-LED chip 1, partially converted to red wavelengths by the R phosphor 28R, and is emitted to the outside. This also applies to the other micro UV-LED chips 1.

Thus, in the present embodiment, the red, green, and blue phosphors are excited in the identical type of micro UV-LED chips 1 to obtain full color, so that mass transfer is possible by transfer instead of pick-and-place.

The spectrum of the micro-UV-LED chips 1 has a weak visible light component, and therefore if the characteristics of the UV-LEDs vary, there is little influence on light emission color of the phosphors.

Since micro-sizing of the micro UV-LED chips 1 causes a relative increase of an area ratio of the side surfaces, adopting the V-chip structure can enhance the efficiency of light extraction from the side surfaces. Such enhancement in light extraction efficiency becomes further noticeable by adopting the side surfaces of the micro UV-LED chips 1 that are formed into inclined surfaces, together with the reflective barrier member 24.

Moreover, using the copper tungsten (CuW) substrate 10 increases the heat dissipation characteristics and allows input of a larger drive current. The decrease in the luminous efficiency due to heat generation at the time of driving can also be suppressed.

Description will now be given of a method of manufacturing a micro-LED display in the present embodiment.

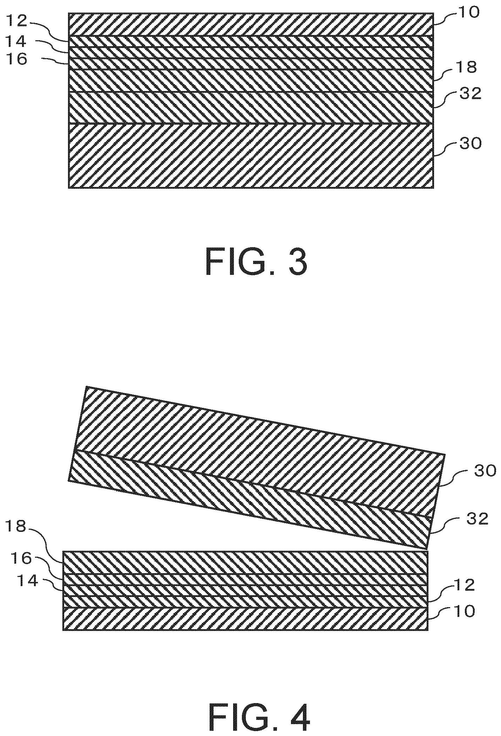

FIGS. 3 to 11 are schematic sectional views showing the manufacturing method of a micro-LED display. First, as shown in FIG. 3, the GaN buffer layer 32, the n-type layer 18, the light-emitting layer 16, and the p-type layer 14 are epitaxially grown in order on the sapphire substrate 30 by a metal organic chemical vapor deposition method (MOCVD method) to form an LED structure. Here, the n-type layer 18 includes a superlattice structure (SLS) layer, and the p-type layer 14 also includes the superlattice structure (SLS). Additionally, the light-emitting layer 16 includes the MQW layer made of (InGaN/ AlGaN).

Then, on the p-type layer, the transparent electrode 12 is formed by vapor deposition, and the conductive substrate 10 with a thickness of about 100 µm, such as the substrate 10 made of copper tungsten (CuW), is bonded onto the transparent electrode 12.

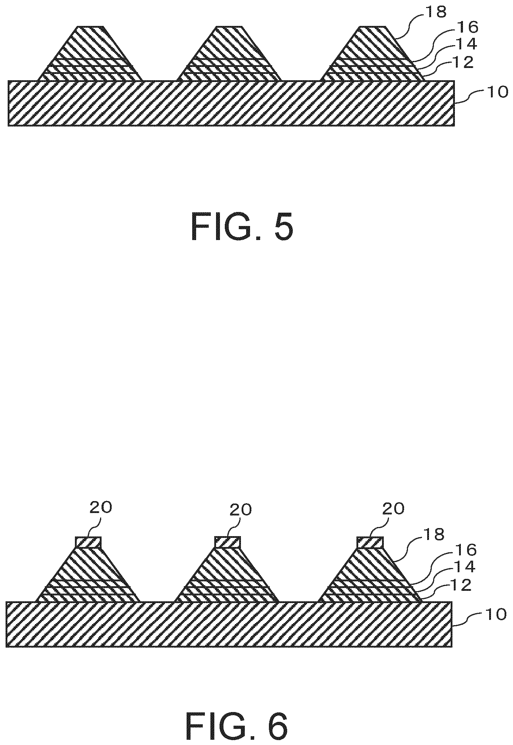

Next, as shown in FIG. 4, the sapphire substrate 30 and the GaN buffer layer 32 are lifted off, and then, as shown in FIG. 5, isolation etching is performed from the n-layer side to form a plurality of micro LED chips with a size of 100 µm or less, and more preferably with a chip size of 50 µm or less. In the isolation etching step, the sides of the micro-LED chips are etched so that the side surfaces become inclined surfaces (tapered surfaces). A publicly known technique is used to form the inclined surfaces. The angle of the inclined surfaces, that is, the angle made with respect to the stacking direction of the micro LED chips, is 45 degrees, for example.

Next, as shown in FIG. 6, the n-electrodes 20 are formed on the respective surfaces of the n-type layers of the isolated micro-LED chips by vapor deposition.

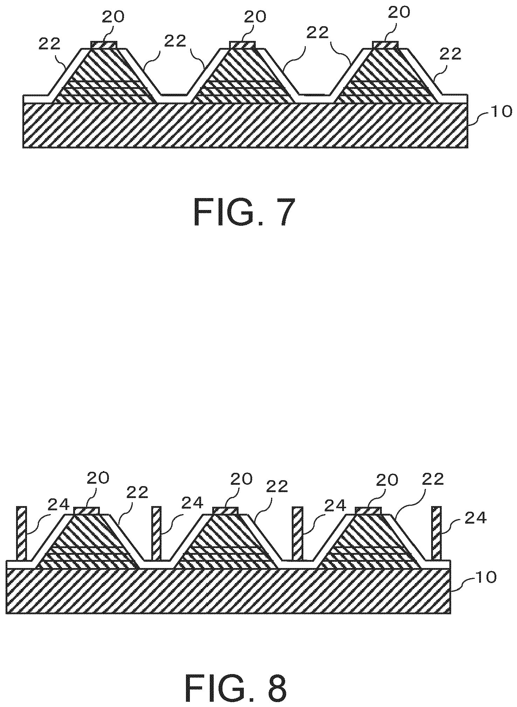

Next, as shown in FIG. 7, the passivation layer 22 made of SiO₂ is formed on n-layer side regions of all the micro-LED chips other than the n-electrodes 20 for passivation.

Next, as shown in FIG. 8, the reflective barrier member 24 made of a highly reflective material, such as aluminum, is formed between the adjacent micro LED chips.

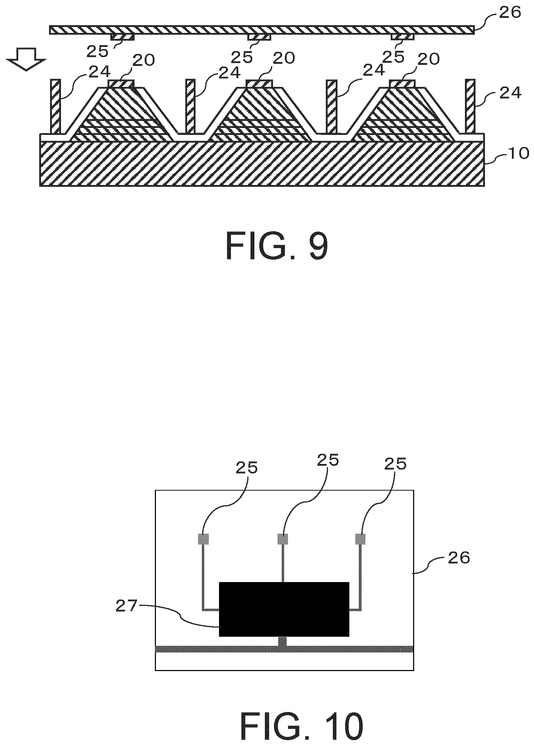

Next, as shown in FIG. 9, the film-like wiring substrate 26 having the n-type electrodes 25 is laminated so that n-electrodes 20 of all the micro LED chips are joined with the n-type electrodes 25.

FIG. 10 shows a partial plan view of the film-like wiring substrate 26. This is the configuration of one pixel corresponding to the adjacent three micro LED chips. The three n-type electrodes 25 are arranged, and these three n-type electrodes 25 are connected to the drive circuit 27.

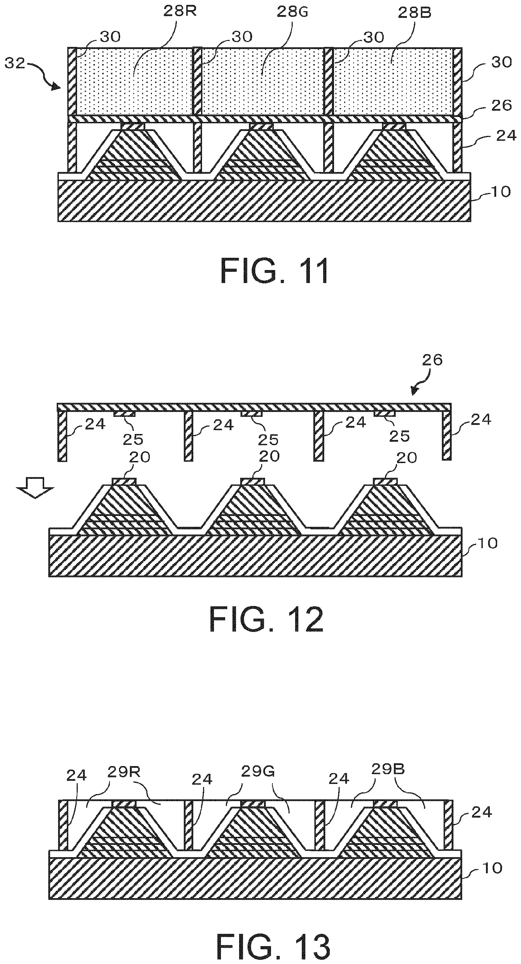

Then, as shown in FIG. 11, the film-like wavelength conversion layer 32 to which with the R phosphor 28R, the G phosphor 28G, and the B phosphor 28B have been applied, and which are separated from each other by a barrier member 30, are laminated onto the micro-LED chips.

By manufacturing the micro-LED display in the above steps, mass transfer can be performed instead of pick-and-place, and the time required for mounting can be shortened. Specifically, in the case of individually manufacturing RGB or UV LED chips and using these LED chips as pixels to manufacture a display, it is essential to mount a large number of very small LEDs of 50 µm or less with high accuracy. Compared with the case of individually picking up these LED chips, the time can be reduced significantly.

In addition, since the sapphire substrate 30 and the GaN buffer layer 32 are lifted off for manufacturing, there is no step of dicing the sapphire substrate 30 with a laser, and therefore there is no damage to the side surfaces of the LED chips due to heat generation caused by laser irradiation, so that the decrease in luminous efficiency thereby can be avoided. Specifically, in the case where the flip chip structure is adopted, the red GaP-based LEDs is laminated on the sapphire substrate to secure strength, and then diced by an excimer laser as in the case of the green and blue InGaN-based LEDs, the heat in the dicing step severely damages the side surfaces of the chips, and the luminous efficiency of the chips decreases due to blackening, etc. However, the manufacturing method in the present embodiment can prevent such damage caused by heat and can avoid the decrease in the luminous efficiency.

Moreover, the V-chip structure is used instead of the flip-chip structure where electrodes are arranged parallel, the space used to arrange the n-electrodes of flip-chips becomes unnecessary, and thus the number of chips that can be manufactured from a growth wafer is increased (approximately doubled).

In addition, the side surfaces of the LED chips are formed into the inclined surfaces in the isolation etching step, so that the area of the side surfaces of the light-emitting layer is increased, and also the reflective barrier member 24 is erected parallel to the stacking direction, which results in enhancement in efficiency of light extraction from the lateral direction is improved.

### <First Modification>

In the embodiment, the reflective barrier member 24 is erected between the micro LED chips, and then the film-like wiring substrate 26 is laminated, though the film-like wiring substrate 26 including the reflective barrier member 24 may be positioned and laminated so that the reflective barrier member 24 is positioned between the micro LED chips.

FIG. 12 shows a sectional view of a first modification. As shown in FIG. 7, after the SᵢO₂ passivation layer 22 is formed, the film-like wiring substrate 26, including the reflective barrier member 24 that is formed according to the pixel size, is laminated so that the reflective barrier member 24 is inserted between the micro LED chips, and the respective n-electrodes 20 of the micro LED chips are joined to the n-type electrodes 25 of the wiring substrate 26.

According to this manufacturing method, the wiring substrate 26 and the reflective barrier member 24 are integrated, so that the arrangement position of the reflective barrier member 24 can be fixed more firmly, and the manufacturing steps can be further simplified.

### <Second Modification>

In the present embodiment, the reflective barrier member 24 is erected between the micro LED chips, and then the film-like wiring substrate 26 is laminated. However, after the reflective barrier member 24 is erected, the gaps between the micro LED chips and the reflective barrier member 24 may be filled with a phosphor-dispersed silicone resin, and then the film-like wiring substrate 26 may be laminated.

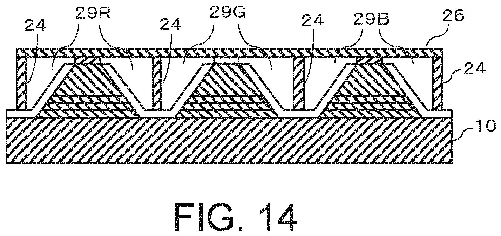

FIG. 13 shows a sectional view of a second modification. As shown in FIG. 8, after the reflective barrier member 24 is erected between the micro LED chips, the gaps between the micro LED chips and the reflective barrier member 24 are filled with phosphor-dispersed silicone-based resins 29R, 29G, and 29B. Then, the film-like wiring substrate 26 is laminated as shown in FIG. 14.

According to this configuration, since the phosphor-dispersed silicone-based resin is filled, there is no need to apply phosphors after the film-like wiring substrate 26 is laminated as shown in FIG. 11, so that the effect of simplifying the steps can be obtained. Note that after the silicone-based resin is filled, the film-like wavelength conversion layer 32 may be laminated on the micro LED chips as necessary.

### REFERENCE SIGNS LIST

1 Micro LED (Micro UV-LED chip), 10 Substrate, 16 Light-emitting layer, 20 n-electrode, 22 Passivation layer, 24 Reflective barrier member, 26 Wiring substrate, 28R R (red) phosphor, 28G G (green) phosphor, 28B B (blue) phosphor, 30 Barrier member, 32 Wavelength conversion layer.

## Claims

1. A micro LED display, comprising:
a first conductive-type electrode;
a plurality of micro LEDs that are separately formed on the first conductive-type electrode and each configured to emit ultraviolet light with a wavelength of 405 nm or less;
second conductive-type electrodes formed on the plurality of micro LEDs, respectively;
a reflective barrier member erected between the plurality of micro LEDs to reflect light from side surfaces of the micro LEDs;
a film-like wiring substrate having a wiring structure that is connected with the second conductive-type electrodes of three micro LEDs that are adjacent to each other, out of the plurality of micro LEDs, so as to constitute one pixel; and
a film-like wavelength conversion layer provided on the wiring substrate, and including phosphors that perform wavelength conversion of respective light from the three micro LEDs into red, green, and blue colors, wherein
the side surfaces of the micro LEDs are formed into inclined surfaces such that widths of the micro LEDs gradually decrease from the first conductive-type electrode toward the second conductive-type electrodes, and
the reflective barrier member is erected parallel to a stacking direction of the plurality of micro LEDs and up to a height equal to the micro LEDs.

2. The micro LED display according to claim 1, further comprising:
a phosphor-dispersed resin that is filled between the micro LEDs and the reflective barrier layer.

3. A micro LED display, comprising:
a first conductive-type electrode;
a plurality of micro LEDs that are separately formed on the first conductive-type electrode and each configured to emit ultraviolet light with a wavelength of 405 nm or less;
second conductive-type electrodes formed on the plurality of micro LEDs, respectively;
a reflective barrier member erected between the plurality of micro LEDs to reflect light from side surfaces of the micro LEDs;
a film-like wiring substrate having a wiring structure that is connected with the second conductive-type electrodes of three micro LEDs that are adjacent to each other, out of the plurality of micro LEDs, so as to constitute one pixel; and
a phosphor-dispersed resin that is filled between the micro LEDs and the reflective barrier layer, the resin being configured to perform wavelength conversion of respective light from the three micro LEDs into red, green, and blue colors, wherein
the side surfaces of the micro LEDs are formed into inclined surfaces such that widths of the micro LEDs gradually decrease from the first conductive-type electrode toward the second conductive-type electrodes, and
the reflective barrier member is erected parallel to a stacking direction of the plurality of micro LEDs and up to a height equal to the micro LEDs.

4. The micro LED display according to any one of claims 1 to 3, wherein
the first conductive-type electrode is a conductive substrate made of tungsten copper.

5. A manufacturing method of a micro LED display, comprising:
a step of epitaxially growing a GaN buffer layer, an n-type layer, a light-emitting layer, and a p-type layer on a sapphire substrate, in order;
a step of forming a transparent electrode on the p layer by vapor deposition;
a step of bonding a conductive substrate onto the transparent electrode;
a step of lifting off the sapphire substrate and the GaN buffer layer;
a step of forming a plurality of micro LEDs by etching from a side of the n-type layer, while forming inclined surfaces on side surfaces of the micro LEDs;
a step of forming n-electrodes on the plurality of micro LEDs by vapor deposition, respectively;
a step of forming a passivation layer on parts of the plurality of micro LEDs other than the n-electrodes;
a step of erecting a reflective barrier member between the plurality of LEDs;
a step of forming a film-like wiring substrate on the n-electrodes such that three micro LEDs that are adjacent to each other, out of the plurality of micro LEDs, constitute one pixel; and
a step of forming a film-like wavelength conversion layer on the wiring substrate, the wavelength conversion layer including phosphors that perform wavelength conversion of respective light from the three micro LEDs into red, green, and blue colors, wherein
the side surfaces of the micro LEDs are formed into inclined surfaces such that widths of the micro LEDs gradually decrease from the conductive substrate toward the n-type layer, and
the reflective barrier member is erected parallel to a stacking direction of the plurality of micro LEDs and up to a height equal to the micro LEDs.

6. The manufacturing method according to claim 5, wherein
the step of erecting the reflective barrier member between the plurality of LEDs, and the step of forming the film-like wiring substrate on the n-electrodes such that three micro LEDs that are adjacent to each other, out of the plurality of micro LEDs, constitute one pixel, are concurrently performed.

7. The manufacturing method according to claim 5, further comprising
a step of filling a phosphor-dispersed resin between the micro LEDs and the reflective barrier layer, after the step of erecting the reflective barrier member between the plurality of LEDs.

8. A manufacturing method of a micro LED display, comprising:
a step of epitaxially growing a GaN buffer layer, an n-type layer, a light-emitting layer, and a p-type layer on a sapphire substrate, in order;
a step of forming a transparent electrode on the p layer by vapor deposition;
a step of bonding a conductive substrate onto the transparent electrode;
a step of lifting off the sapphire substrate and the GaN buffer layer;
a step of forming a plurality of micro LEDs by etching from a side of the n-type layer, while forming inclined surfaces on side surfaces of the micro LEDs;
a step of forming n-electrodes on the plurality of micro LEDs by vapor deposition, respectively;
a step of forming a passivation layer on parts of the plurality of micro LEDs other than the n-electrodes;
a step of erecting a reflective barrier member between the plurality of LEDs;
a step of filling a phosphor-dispersed resin between the micro LEDs and the reflective barrier layer, the resin being configured to perform wavelength conversion of respective light from the three micro LEDs into red, green, and blue colors; and
a step of forming a film-like wiring substrate on the n-electrodes such that the three micro LEDs that are adjacent to each other, out of the plurality of micro LEDs, constitute one pixel, wherein
the side surfaces of the micro LEDs are formed into inclined surfaces such that widths of the micro LEDs gradually decrease from the conductive substrate toward the n-type layer, and
the reflective barrier member is erected parallel to a stacking direction of the plurality of micro LEDs and up to a height equal to the micro LEDs.

9. The manufacturing method according to any one of claims 5 to 8, wherein
the conductive substrate is made of tungsten copper.
